# EUROPÄISCHE PATENTSCHRIFT

(11) **EP 1 792 349 B1**
(45) Veröffentlichungstag und Bekanntmachung des Hinweises auf die Patenterteilung: **30.03.2011**
(21) Anmeldenummer: 05791311.3
(22) Anmeldetag: 14.09.2005
(51) Int. Cl.: H01L 31/18, H01L 31/04

(54) **VERFAHREN ZUR GLEICHZEITIGEN REKRISTALLISIERUNG UND DOTIERUNG VON HALBLEITERSCHICHTEN UND NACH DIESEM VERFAHREN HERGESTELLTE HALBLEITERSCHICHTSYSTEME**
METHOD FOR SIMULTANEOUSLY RECRYSTALLISING AND DOPING SEMI-CONDUTOR LAYERS AND SEMI-CONDUCTOR SYSTEM PRODUCED ACCORDING TO SAID METHOD
PROCEDE DE RECRISTALLISATION ET DE DOPAGE SIMULTANES DE COUCHES SEMI-CONDUCTRICES ET SYSTEMES DE COUCHES SEMI-CONDUCTRICES FABRIQUES SELON LEDIT PROCEDE

(30) Priorität: 15.09.2004 DE 102004044709
(43) Veröffentlichungstag der Anmeldung: 06.06.2007
(73) Patentinhaber: Fraunhofer-Gesellschaft zur Förderung der angewandten Forschung e.V., 80686 München (DE)
(72) Erfinder: REBER, Stefan, D-79194 Gundelfingen (DE)
(74) Vertreter: Pfenning, Meinig & Partner GbR
(86) Internationale Anmeldenummer: PCT/EP2005/009898
(87) Internationale Veröffentlichungsnummer: WO 2006/029849

(56) Entgegenhaltungen:
- US-A- 5 192 991
- US-A- 5 238 879
- US-A- 5 810 945
- ARIMOTO S ET AL: "HIGH-EFFICIENT OPERATION OF LARGE-AREA (100 CM2) THIN FILM POLYCRISTALLINE SILICON SOLAR CELL BASED ON SOI STUCTURE" SOLAR ENERGY MATERIALS AND SOLAR CELLS, ELSEVIER SCIENCE PUBLISHERS, AMSTERDAM, NL, Bd. 34, Nr. 1 - 4, 1. September 1994 (1994-09-01), Seiten 257-262, XP000728744 ISSN: 0927-0248
- ISHIHARA T ET AL: "ZONE-MELTING RECRYSTALLIZATION OF SILICON THIN FILMS FOR SOLAR CELLAPPLICATION" PROGRESS IN PHOTOVOLTAICS. RESEARCH AND APPLICATIONS, JOHN WILEY AND SONS, CHICHESTER, GB, Bd. 3, Nr. 2, 1. März 1995 (1995-03-01), Seiten 105-113, XP000502946 ISSN: 1062-7995
- MAUK M G ET AL: "Large-grain (>1-mm), recrystallized germanium films on alumina, fused silica, oxide-coated silicon substrates for III-V solar cell applications" JOURNAL OF CRYSTAL GROWTH, ELSEVIER, AMSTERDAM, NL, Bd. 250, Nr. 1-2, März 2003 (2003-03), Seiten 50-56, XP004412902 ISSN: 0022-0248
- NIJS J ET AL: "Overview of solar cell technologies and results on high efficiency multicrystalline silicon substrates" SOLAR ENERGY MATERIALS AND SOLAR CELLS, ELSEVIER SCIENCE PUBLISHERS, AMSTERDAM, NL, Bd. 48, Nr. 1-4, November 1997 (1997-11), Seiten 199-217, XP004111851 ISSN: 0927-0248
- RATH J K: "Low temperature polycrystalline silicon: a review on deposition, physical properties and solar cell applications" SOLAR ENERGY MATERIALS AND SOLAR CELLS, ELSEVIER SCIENCE PUBLISHERS, AMSTERDAM, NL, Bd. 76, Nr. 4, 1. April 2003 (2003-04-01), Seiten 431-487, XP004409563 ISSN: 0927-0248

## Beschreibung

Die vorliegende Erfindung bezieht sich auf ein Verfahren zur gleichzeitigen Rekristallisierung und Dotierung von Halbleiterschichten insbesondere zur Herstellung von kristallinen silizium-Dünnschichtsolarzellen und auf nach diesem Verfahren hergestellte Halbleiterschichtsysteme, insbesondere kristalline Silizium-Dünnschichtsolarzellen,

Aus dem Stand der Technik (US 5,192,991 A) sind polykristalline Solarzellen und Herstellungsverfahren für dieselben bekannt. Hierbei wird insbesondere auf einem Substrat ein Elektrodenfilm und auf diesem eine n-dotierte Halbleiterschicht aus amorphem Silizium, eine intrinsische Halbleiterschicht aus amorphem Silizium und eine p-dotierte Schicht aus amorphem Silizium abgeschieden. Die Abscheidung geschieht hierbei mit Plasma-CVD. Anschließend werden die Schichten thermisch rekristallisiert und es wird ein oberer Elektrodenfilm abgeschieden.

Der Stand der Technik kennt darüberhinaus (Arimoto S. et al. "High efficient operation of large-area thin film polycrystalline silicon solar cell based on SOI structure", Solar Energy Materials and Solar Cells, ELSEVIER Science Publishers, Amsterdam, Bd. 34, Nr. 1-4, 1. September 1994, Seiten 257-262) die Herstellung von siliziumbasierten Solarzellen auf Basis von Zonenschmelz-Rekristallisierschritten ZMR. Hierbei wird auf einem Substrat aus Silizium zunächst eine SiO₂-Isolationsschicht abgeschieden, dann erfolgt die Abscheidung einer Schicht aus polykristallinem Silizium. Letztere wird dann mittels ZMR rekristallisiert. Anschließend wird eine Aktivschicht (p-dotiert) auf der rekristallisierten Schicht abgeschieden.

Schließlich kennt der Stand der Technik (Ishihara T. et al. "Zone-melting recrystallization of silicon thin films for solar cell application", Progress in Photovoltaics, Research and Applications, John Wiley & Sons, Bd. 3, Nr. 2, 1. März 1995, Seiten 105-113) ein ähnliches Verfahren, wie es in dem vorstehenden Absatz beschrieben wurde, bei welchem jedoch auch die Abscheidung einer capping-schicht erfolgt.

Die Herstellung von dünnen, dotierten Halbleiterschichten bzw. Schichtsystemen für Elektronik und Photovoltaik wird derzeit auf verschiedenste Arten durchgeführt. Im allgemeinen ist es das Ziel, sandwichartige Schichtstrukturen aus unterschiedlich dotierten Teilschichten zu realisieren. Dabei kommen typischerweise mehrere Prozessschritte zum Einsatz, mit welchen eine solche Schichtstruktur sequentiell aufgebaut wird. Das Aufbauen geschieht entweder durch Aufwachsen von Teilschichten (Abscheidung, Epitaxie) oder durch Eintreiben eines Dotierstoffs (beispielsweise durch Diffusion oder Implantation). Die Verfahren sind typischerweise dadurch gekennzeichnet, dass zum Herstellen mehrerer unterschiedlich dotierter Schichten mehrere Eintreibprozesse oder Abscheideprozesse benötigt werden. Ausnahmen sind sog. Co-Diffusionsprozesse, bei denen aus unterschiedlichen Dotierstoffquellen gleichzeitig unterschiedlich dotierte Schichten hergestellt werden.

Die vorliegende Erfindung betrifft Halbleiter-Schichtstrukturen, bei denen der Halbleiter nach einem Abscheideschritt noch über die Flüssigphase rekristallisiert wird, um beispielsweise die Kristallstruktur zu ändern. Eine solche Anwendung ist beispielsweise in der "Silicon on Insulator" (SOI)-Technologie gegeben oder im Bereich der kristallinen Silizium-Dünnschichtsolarzellen. Insbesondere an letzterem System wird die Erfindung nachfolgend beispielhaft erläutert.

Kristalline Silizium-Dünnschichtsolarzellen werden gegenwärtig durch unterschiedliche Verfahren hergestellt. Eines dieser Verfahren nach dem Stand der Technik besteht aus den folgenden Prozessschritten:
1. Herstellen eines Substrates.
2. Abscheidung einer leitfähigen Zwischenschicht.
3. Abscheidung einer Keimschicht, welche üblicherweise mit Dotierstoff angereichert ist, der in der Keimschicht eine n- oder p-Leitung hevorruft.
4. Aufbringen einer "Capping"-Schicht durch Abscheidung oder thermisches Oxidieren.
5. Aufheizen und Rekristallisierung' der Keimschicht.
6. Entfernen der Capping-Schicht.
7. Abscheiden der photovoltaisch aktiven Absorberschicht.
8. Herstellung des pn-Übergangs durch Eintreiben eines Dotierstoffs in die aktive Absorberschicht.
9. Aufbringen der Metallisierung.

Die Keimschicht dient dabei sowohl dem Zweck, Kristallisationskeime für die epitaktische Abscheidung des Absorbers zu bilden, als auch zur Ausbildung eines sog. "Back Surface Fields" (BSF) zur Verminderung von Ladungsträger-Rekombinationen. Hierzu ist die Keimschicht üblicherweise hochdotiert.

Ausgehend vom Stand der Technik ist es die Aufgabe der vorliegenden Erfindung, das separate Abscheiden der photovoltaisch aktiven Absorberschicht überflüssig werden zu lassen, ohne an der Funktionalität des prinzipiellen Aufbaus, insbesondere dem Vorhandensein der BSF-Schicht, Abstriche machen zu müssen.

Diese Aufgabe wird durch das Herstellungsverfahren nach Patentanspruch 1, das danach hergestellte Halbleiterschichtsystem nach Patentanspruch 38 sowie das System nach Anspruch 39 gelöst. Vorteilhafte Weiterbildungen des erfindungsgemäßen Verfahrens werden in den jeweiligen abhängigen Patentansprüchen beschrieben.

Im erfindungsgemäßen Verfahren werden die folgenden Prozessschritte modifiziert:
Prozessschritt 2: Statt einer undotierten Zwischenschicht wird ein aus mindestens einer Teilschicht bestehendes Schichtsystem abgeschieden. Mindestens eine der Teilschichten des Schichtsystems besitzt einen Anteil an Dotierstoff, der in der aktiven Absorberschicht als Akzeptor oder Donator wirken kann.
Prozessschritt 3: Das Niveau der Dotierung der im dritten Prozessschritt abgeschiedenen Schicht wird niedriger oder gleich der Dotierung, die für den Absorber des fertig hergestellten Halbleiterschichtsystems bzw. der fertig hergestellten Dünnschichtsolarzelle notwendig ist, gewählt.

Hierbei wird die Absorberschicht dotiert, indem der Rekristallisationsschritt so gesteuert wird oder indem so aufgeheizt, abgekühlt und getempert wird, dass erster Dotierstoff aus dem Zwischenschichtsystem in die Absorberschicht eindiffundiert, während diese geschmolzen ist und/oder während diese wieder erstarrt und/oder während diese erstarrt ist.

Durch diese beiden Prozessschrittmodifikationen kann der Prozessschritt 7 (d.h. die separate Abscheidung der Absorberschicht) entfallen, weil aufgrund von nachfolgend beschriebenen Abläufen im Rekristallisierungsschritt (Schritt 5) die im Prozessschritt 3 abgeschiedene Schicht als Absorber verwendet werden kann. Das Wesen des erfindungsgemäßen Verfahrens liegt letztendlich darin, dass sowohl die Ausbildung einer BSF-Schicht als auch die Dotierung der aktiven Absorberschicht während des Rekristallisationsschrittes erfolgen kann. Der Rekristallisationsschritt und der Dotierschritt erfolgen gleichzeitig. Die Ausbildung der BSF-Schicht folgt unmittelbar der gleichzeitig stattfindenden Rekristallisierung und Dotierung, so dass die Ausbildung der BSF-Schicht, die Rekristallisation und die Dotierung der Absorberschicht in einem Hochtemperaturschritt in-situ geschehen.

In einer vorteilhaften Ausgestaltungsvariante wird auch Prozessschritt 4 modifiziert. Statt einer undotierten Capping-Schicht wird ein aus mindestens einer Teilschicht bestehendes Schichtsystem abgeschieden. Mindestens eine dieser Teilschichten des abgeschiedenen Capping-Schichtsystems besitzt einen Anteil an Dotierstoff, welcher dem der Absorberschicht komplementär ist. Diese Ausgestaltungsform bewirkt die Herstellung eines pn-Übergangs gleichzeitig mit der Herstellung der BSF-Schicht unmittelbar nach der Wiedererstarrung im selben Hochtemperaturschritt. Nach Entfernen der Capping-Multischicht kann dann unmittelbar mit der Metallisierung der Solarzelle begonnen werden.

Zusätzlich kann durch eine weitere Rekristallisierung der Emitter-/Absorberschicht an der der Substratbasis abgewandten Oberfläche mit gezielter Einstellung der Dicke des verflüssigten Siliziums eine Emitterschicht beliebiger, die Absorberdicke unterschreitenden Dicke hergestellt werden.

In einer weiteren vorteilhaften Ausgestaltungsvariante sind die dotierte Teilschicht des Zwischenschichtsystems und die dotierte Teilschicht des Capping-Schichtsystems komplementär dotiert zu der Dotierung der in Prozessschritt 3 (späterer Absorber) abgeschiedenen Schicht. In diesem Fall wird ein pnp- oder ein npn-dotiertes System hergestellt. Ebenso kann das Zwischenschichtsystem komplementär zu dem Capping-Schichtsystem und zu der in Prozessschritt 3 abgeschiedenen Schicht (spätere Absorberschicht) dotiert sein. Dies führt dann zu npp⁺ oder pnn⁺ dotierten Systemen. Auch weitere Permutationen sind möglich (p⁺pn oder n⁺np-Systeme) .

Die Vorteile des erfindungsgemäßen Verfahrens liegen in der vereinfachten Prozessabfolge, welche es insbesondere erlaubt, kostengünstig kristalline Silizium-Dünnschichtsolarzellen herzustellen: Der Schichtaufbau und die Funktionalität des Schichtsystems kann mit weniger Prozessschritten erreicht werden.

Das erfindungsgemäße Verfahren für die Herstellung von dotierten Halbleiterschichtsystemen bzw. nach diesem Verfahren hergestellte Halbleiterschichtsysteme können wie in dem nachfolgend beschriebenen Beispiel hergestellt werden oder ausgeführt sein. Das Beispiel beschreibt eine kristalline Silizium-Dünnschichtsolarzelle, was jedoch zu keiner Einschränkung des Schutzumfangs, wie er durch die Patentansprüche gegeben ist, führt.

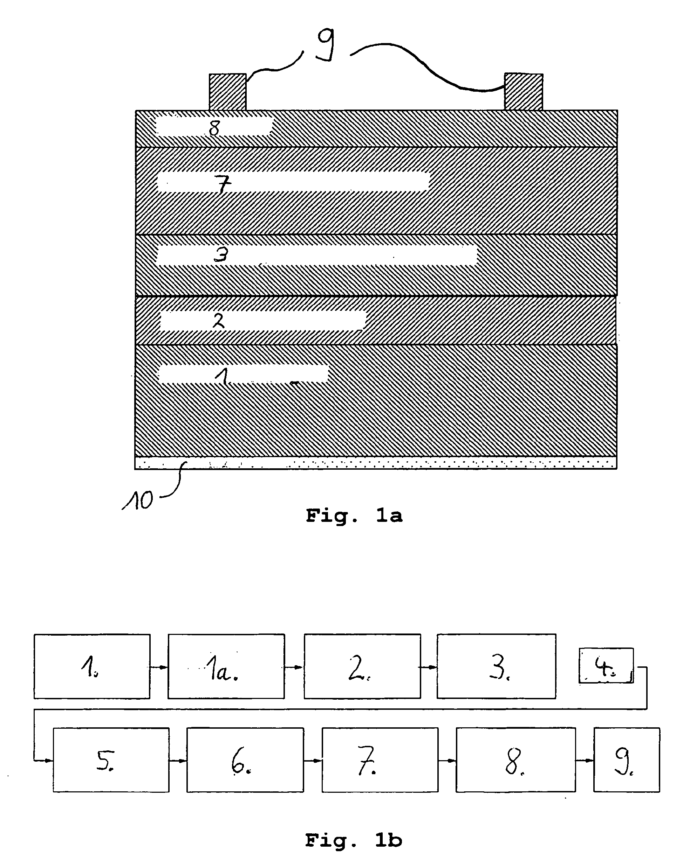

Es skizziert Figur 1 die Herstellung einer kristallinen Silizium-Dünnschichtsolarzelle mit einem Verfahren nach dem gegenwärtigen Stand der Technik.

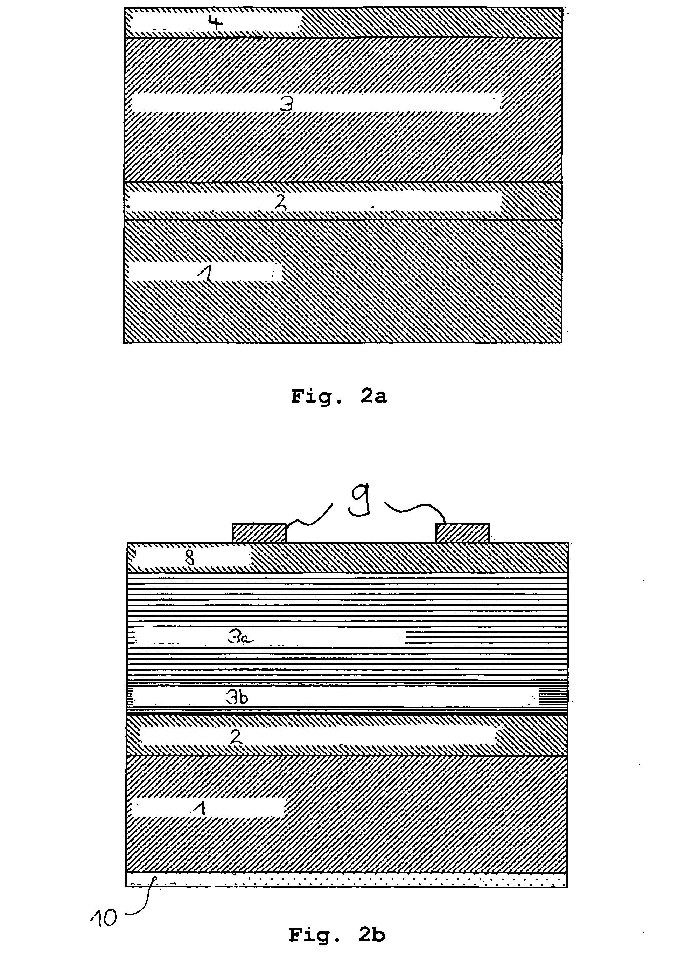

Es skizziert Figur 2 die Herstellung einer kristallinen Silizium-Dünnschichtsolarzellen mit dem erfindungsgemäßen Verfahren.

Figur 1a zeigt ein Substrat 1, auf dem eine leitfähige SiC-Schicht 2 als Zwischenschicht angeordnet ist. Auf der der Zwischenschicht abgewandten Seite ist an der Substratunterseite ein metallischer Basiskontakt 10 angebracht. Auf der Zwischenschicht 2 ist eine Keimschicht 3 aus Silizium angeordnet. Diese Keimschicht 3 liegt in rekristallisierter, hochdotierter (für Solarzellen üblicherweise > 10¹⁸ at/em³ Dotierstoff) Form vor. Auf der hochdotierten Keimschicht 3 ist eine normal dotierte (üblicherweise 10¹⁶-10¹⁷ Atome/cm³) Silizium-Absorberschicht 7 angeordnet.

In Bezug auf das Substrat 1 gesehen oberhalb der Absorberschicht 7 befindet sich die Emitterschicht 8, auf der zwei metallische Emitterkontakte 9 angeordnet sind.

Figur 1b zeigt die Prozessabfolge, welche zur Herstellung eines Schichtsystems der rekristallisierten kristallinen Silizium-Dünnschichtsolarzelle nach Figur 1a führt. Im Schritt 1 wird das Substrat durch Bandziehen hergestellt (Keramik/Si-Band). Anschließend erfolgt im Schritt 1a die Reinigung des Substrats. Im nächsten Schritt 2 erfolgt die Abscheidung der dotierten oder undotierten, leitfähigen Zwischenschicht. Auf der dotierten oder undotierten Zwischenschicht 2 wird im Prozessschritt 3 die Keimschicht aus Silizium abgeschieden. Diese ist mit Dotierstoff angereichert, der im vorliegenden Fall dazu geeignet ist, in der Keimschicht eine n-Leitung hervorzurufen. Der Dotierstoff kann jedoch auch eine p-Leitung-hervorrufen. In Prozessschritt 4 wird eine Capping-Schicht abgeschieden. Diese besteht im vorliegenden Fall aus SiO₂. Das Aufbringen der Capping-Schicht kann auch durch thermisches Oxidieren erfolgen. In Prozessschritt 5, dem Rekristallisierungsschritt, wird die Siliziumschicht 3 bzw. die Keimschicht 3 durch Schmelz-Rekristallisierung (im vorliegenden Fall Zonenschmelz-Rekristallisierung) aufgeheizt und rekristallisiert. Der Rekristallisierungsschritt 5 besteht aus drei Teilprozessen: Zum ersten dem Schmelzprozess, bei dem das Silizium der Keimschicht 3 in flüssiger Phase vorliegt, zum zweiten dem Erstarrungsprozess, bei dem das flüssige Silizium üblicherweise gerichtet erstarrt und zum dritten einem Temperprozess (bei dem das Silizium auf einer Temperatur in der Nähe, aber unterhalb der Schmelztemperatur gehalten wird, um eingefrorene Spannungen abzubauen), nach dem Schmelz- und Erstarrungsprozess, bei dem das Silizium als Festkörper vorliegt.
Im nachfolgenden Schritt 6 wird die Capping-Schicht 4 wieder entfernt. Danach erfolgt im Prozessschritt 7 die Abscheidung der photovoltaisch aktiven Silizium-Absorberschicht 7. Im nachfolgenden Schritt 8 wird der pn-Übergang hergestellt. Dies erfolgt im vorliegenden Fall durch Drucken, Sprühen oder Abscheiden einer mit Dotierstoff (dieser Dotierstoff ist komplementär zum in der Absorberschicht 7 vorhandenen Dotierstoff, führt also im vorliegenden Fall zu einer p-Leitung, kann jedoch auch bei einer p-Leitung in der Absorberschicht 7 zu einer n-Leitung führen) angereicherten Quellenschicht mit nachfolgendem oder gleichzeitigem Eintreiben des Dotierstoffs in die aktive Absorberschicht 7 durch Tempern. Hierdurch entsteht die Emitterschicht 8. Im Schritt 9 erfolgt schließlich das Aufbringen der Metallisierung bzw. der Emitterkontakte 9 und des Basiskontakts 10. Die Silizium-Keimschicht 3 dient zwei Zwecken: Durch sie werden Kristallisationskeime für das epitaktische Abscheiden des Siliziumabsorbers 7 ausgebildet und sie dient der Ausbildung eines sog. "Back Surface Fields" (BSF)-Schicht zur Verminderung der Ladungsträger-Rekombination an der Grenzfläche von der Zwischenschicht 2 zum Silizium. Hierzu ist die Keimschicht 3 im vorliegenden Fall hochdotiert.

Die Figuren 2a (vor dem Schmelzprozess) und 2b (nach dem Schmelzprozess und der Metallisierung) zeigen, wie im erfindungsgemäßen Verfahren im Gegensatz zum Verfahren nach dem Stand der Technik (Figur 1) der Prozessschritt der Silizium-Epitaxie (separates Abscheiden der aktiven Silizium-Absorberschicht im Prozessschritt 7) überflüssig wird, ohne dass an der Funktionalität des prinzipiellen Aufbaus, speziell dem Vorhandensein einer BSF-Schicht, Abstriche gemacht werden müssen. In den Figuren sind Schichten bzw. Schichtsystem-Bestandteile, die mit den Schichten bzw. Schichtsystem-Bestandteilen in Figur 1a übereinstimmen oder Schichtsystembestandteilen der in Figur 1a gezeigten Anordnung entsprechen mit identischen Bezugszeichen gekennzeichnet. Im erfindungsgemäßen Prozess wird in Prozessschritt 2 statt einer beliebig dotierten oder undotierten Zwischenschicht ein aus mindestens einer Teilschicht bestehendes Zwischenschichtsystem (dieses wird nachfolgend ebenfalls durch das Bezugszeichen 2 gekennzeichnet) abgeschieden. Mindestens eine der Teilschichten dieses Zwischenschichtsystems 2 besitzt einen exakt vorgegebenen Anteil an Dotierstoff, der später in der abzuscheidenden aktiven Absorberschicht als Akzeptor oder Donator wirkt. In Prozessschritt 3 ist das Niveau der in diesem Prozessschritt abgeschiedenen Siliziumschicht (welche die spätere Absorberschicht darstellt) niedriger oder gleich der Dotierung, die für die spätere Absorberschicht bzw. den Solarzellenabsorber notwendig ist. Durch die nachfolgend beschriebenen, im Rekristallisierungsschritt stattfindenden Abläufe kann im erfindungsgemäßen Verfahren die separate Abscheidung des Siliziumabsorbers (im Stand der Technik dem Prozessschritt 7 entsprechend) entfallen. Die Figur 2a zeigt nun ein Schema der erfindungsgemäßen Halbleiter-Schichtkombination vor dem Rekristallisierungsschritt 5. Auf dem leitfähigen Siliziumsubstrat 1 ist die leitfähige Multi-Zwischenschicht 2 bzw. das entsprechende Zwischenschichtsystem 2 angeordnet bzw. abgeschieden worden. Dieses Zwischenschichtsystem 2 ist elektrisch leitfähig kann i. A. aber auch nicht-leitfähig sein (z.B. dotiertes SiO₂ und hochdotiert (im vorliegenden Fall führt die Dotierung zu einer n-Leitung, kann jedoch auch zu einer p-Leitung führen) und besteht im vorliegenden Fall aus einer Teilschicht. Auf dem Zwischenschichtsystem 2 ist auf der substratabgewandten Seite die (spätere) Silizium-Absorberschicht 3 abgeschieden. Diese weist im vorliegenden Fall eine Dotierung (hier: wie die Multi-Zwischen-Schicht 2 n-Dotierung, es kann aber auch eine p-Dotierung sein, wenn das ZwischenSchichtsystem 2 eine solche aufweist) auf, welche niedriger als die Dotierung ist, die sich für den Solarzellenabsorber schlussendlich einstellt. Die spätere Absorberschicht 3 kann jedoch auch undotiert sein (technisch möglich ist hier auch eine leichte Komplementär-Dotierung zur Zwischenschicht, die beim Rekristallisieren überdotiert wird). In Figur 2b sind zwei Abschnitte der Absorberschicht (Abschnitt 3b auf der substratabgewandten Seite unmittelbar angrenzend an das Zwischenschichtsystem und Abschnitt 3a auf der dem Zwischenschichtsystem 2 abgewandten Seite des Abschnitts 3b unmittelbar an den Abschnitt 3b angrenzend) gekennzeichnet. In Abschnitt 3b hat sich nach dem Rekristallisierungsprozess durch Eindiffusion die hochdotierte BSF-Schicht ausgebildet.
Oberhalb der späteren Absorberschicht 3 ist (Fig. 2a) die Capping-Schicht 4 abgeschieden bzw. angeordnet. Diese ist im vorliegenden Fall (was später beschrieben wird) eine Capping-Multischicht bzw. ein Capping-Schichtsystem.

Die Besonderheiten des Zwischenschichtsystems sind wie folgt (diese Besonderheiten gelten ebenso für das später beschriebene Capping-Schichtsystem):

Die Dotierstoffkonzentrationen in Dotierstoff-Quellschichten des Zwischenschichtsystems 2 betragen üblicherweise etwa 10¹⁸ bis 10²² Atome/cm³. Pufferschichten des Schichtsystems 2 können undotiert sein oder Dotierstoffkonzentrationen bis etwa 10¹⁸ Atome/cm³ aufweisen. Diese Werte gelten vor dem Aufschmelzen bzw. dem Rekristallisationsschritt. Nach dem Aufschmelzen bzw. dem Rekristallisationsschritt betragen die Werte für die Dotierstoff-Quellenschicht (diese entspricht der vorgenannten Teilschicht mit dem exakt vorgegebenen Anteil an Dotierstoff) typischerweise etwa > 10¹⁶ Atome/cm³ Die Dotierstoffverteilung kann scharfe Sprünge aufweisen, aber auch entsprechend des Prozesses langsam über den Schichtquerschnitt (senkrecht zur Schichtebene) variieren. Die in dem Zwischenschichtsystem 2 verwendete Schichtanzahl (Quellenschichten und Pufferschichten) richtet sich nach den Notwendigkeiten des Rekristallisationsprozesses. Üblicherweise beträgt sie zwei bis drei Schichten. In der Regel wird hierbei nur eine Schicht als Quellschicht abgeschieden. Die Schichtdicken müssen entsprechend des thermischen Ablaufs des Prozesses eingestellt werden. Üblicherweise werden Schichtdicken in der Größenordnung von 100 bis 1000 nm eingesetzt. Als Schichtmaterialien kommen alle Materialien in Frage, die bei den hohen Prozesstemperaturen (bis etwa 1500°C) Halbleiterreinheit behalten. Es werden daher Verbindungen aus Si, O, C, N, B, P, Al, Ga, Sb, As und/oder In verwendet, insbesondere SiO₂ SiNₓ (x ist eine ganze Zahl, gleich oder größer als 1), SiC, BN und/oder BC.

Wie bereits beschrieben, kann die Dotierung des Zwischenschichtsystems 2 eventuell auch komplementär zur Dotierung der Absorberschicht 3 sein.

Wenn die rückseitig bzw. an der substratzugewandten Seite der späteren Absorberschicht eingetriebene (das Eintreiben kann jedoch auch alternativ hierzu vorderseitig bzw. auf der substratabgewandten Seite der späteren Absorberschicht erfolgen) BSF-Schicht für Dünnschichtsolarzellen genutzt wird, werden üblicherweise für Si-Solarzellen folgende Werte verwendet:
- Schichtdicke der BSF-Schicht (durch das Diffusionsprofil gegeben) im Bereich von 0.1 bis 5 µm
- Dotierstoffkonzentration in der BSF-Schicht im Bereich von etwa 10¹⁷ bis 10²¹ Atome/cm³.

Je nach Material und Anwendung können diese Werte aber auch außerhalb des genannten Bereichs liegen.

Im Prozessschritt 5, dem Rekristallisationsprozess, geschieht folgendes: Während des Schmelz-Teilprozesses wird Dotierstoff aus dem Zwischenschichtsystem 2 herausgelöst und verteilt sich quasi homogen in der Schmelze der späteren Absorberschicht 3. Beim Wiedererstarren der Schmelze der späteren Absorberschicht 3 wird dieser Dotierstoff in die entstehende Absorberschicht eingebaut und aktiviert. Er dient nun der Grunddotierung dieser Schicht, die dadurch zur aktiven Absorberschicht (bzw. der Basis der Solarzelle) wird. Im nachfolgenden Temper- und Abkühlprozess diffundiert weiter Dotierstoff aus dem Zwischenschichtsystem 2 in die neu gebildete Absorberschicht 3. Durch die im Festkörperzustand der Absorberschicht 3 gegenüber der Flüssigphase verringerten Diffusionsgeschwindigkeit akkumuliert sich der Dotierstoff nun an der rückseitigen Oberfläche (d.h. an der dem Zwischenschichtsystem 2 zugewandten Oberfläche der Absorberschicht 3) der Absorberschicht 3 und bildet dadurch im Schichtbereich 3b bedingt durch die Eindiffusion eine hochdotierte BSF-Schicht aus.

Für die Steuerung in der Rekristallisationsphase bzw. im Rekristallisationsschritt stehen die folgenden Parameter zur Verfügung:
Heizleistungen, Verteilung der Heizleistung, Vorschubgeschwindigkeit, Aufheiz-/Abkühlrampen, Höhe (d.h. Temperatur) der Temperplateaus und Temperzeiten. All diese Parameter beeinflussen letztendlich a) die Zeit, in der das Silizium geschmolzen ist und b) den Temperaturverlauf über die Zeit. Der erfindungsgemäße Rekristallisationsprozess lässt sich genauer durch 5 verschiedene Phasen beschreiben:
   1. Aufheiz- und Haltephase (Rampe zur Temperaturerhöhung):
      Diese dauert typischerweise einige Minuten, die Endtemperatur liegt bei Silizium typischerweise im Bereich von 900°C bis 1300°C (bei anderen Materialien muss die Temperatur entsprechend angepasst werden). Die Steuerparameter während dieser Phase sind die Zeit, der Temperaturverlauf, die Plateautemperatur, die Plateauzeit und/oder die Prozessgasatmosphäre.
   2. Schmelzphase:
      Hier erfolgt das Aufschmelzen der Siliziumschicht und das Halten. Wird beim Zonenschmelzprozess durch Heizleistungen, Verteilung der Heizleistung, Vorschubgeschwindigkeit und z.T. auch Prozessgasatmosphäre bestimmt. Bei anderen Schmelzverfahren können die Parameter anders sein bzw. gewählt werden. Typische Zeitdauer: Einige zehntel bis einige zehn Sekunden. Beim Laser- oder Elektronenstrahlrekristallisieren ist die Zeit deutlich kürzer (bis hinunter zu Nanosekunden).
   3. Rekristallisationsphase: Wiedererstarren der geschmolzenen Schicht
      Beim ZMR-Prozess (Zonenschmelz-Rekristallisationsprozess bzw. engl. zone-melting recrystallisation process) bestimmen Vorschubgeschwindigkeit, Heizleistung und Heizleistungsverteilung, Energieabfuhr (Wärmeleitung, Abstrahlung und Konvektion), sowie Richtung der Energieeinkopplung die Rekristallisation. Dies ist wichtig für die Segregation, die während des Wiedererstarrens stattfindet (nachfolgend beschrieben).
   4. Temperphase:
      Die Steuerung ist in dieser Phase nur durch Einstellung von Temperatur und Temperzeiten möglich, d.h. durch das Temperaturprofil über der Zeit. Hier wird die Dotierung eingetrieben und es erfolgt eine Relaxation von Verspannungen des Kristalls. Die Steuerparameter sind in dieser Phase die Temperatur(en), die Haltedauer(n) und/oder die Abkühlgeschwindigkeit(en) (Rampen) .
   5. Abkühlphase:
      Hier erfolgt ein Herunterkühlen des Substratsystems auf Raumtemperatur. Die Parameter zur Steuerung sind hier die Rampendauer und die Rampenform. Insbesondere die Schmelzphase und die Rekristallisationsphase müssen im Zusammenspiel von Diffusion, Löslichkeit und Segregation so gestaltet werden, dass sich das gewünschte Endprofil ergibt.

Das Wesen der Erfindung liegt somit darin, dass die Dotierung der aktiven Absorberschicht 3a sowie die Rekristallisation der Absorberschicht 3a gleichzeitig in einem Hochtemperaturschritt erfolgen und dass im selben Hochtemperaturschritt (am Ende der Phase 3. und während der Phase 4.) unmittelbar anschließend die Realisation der BSF-Schicht 3b erfolgt. Im Anschluss an die bisher beschriebenen Prozessschritte erfolgt noch das Diffundieren des Emitters, das Entfernen des Capping-Schichtsystems 4 sowie die Aufbringung der Metallisierung bzw. der Emitterkontakte 9.

Figur 2b zeigt eine mit dem erfindungsgemäßen Verfahren wie beschrieben hergestellte kristalline Silizium-Dünnschichtsolarzelle. Auf dem leitfähigen Siliziumsubstrat 1 (mit an der Unterseite angebrachtem Basiskontakt 10) ist auf der dem Basiskontakt gegenüberliegenden Oberfläche das leitfähige, hochdotierte Zwischenschichtsystem 2 angeordnet. Oberhalb des bzw. auf der substratabgewandten Seite des Zwischenschichtsystems 2 ist an diesem angrenzend die eindiffundierte, hochdotierte BSF-Schicht 3b angeordnet. Oberhalb der bzw. auf der zwischenschichtabgewandten Seite der BSF-Schicht befindet sich angrenzend an diese dann die normal-dotierte Silizium-Absorberschicht, der eigentliche Absorber der Solarzelle (Bezugszeichen 3a). Am oberen Ende der Schichtfolge, unmittelbar auf der Absorberschicht 3a (auf deren BSF-Schicht-abgewandten Seite), ist die Emitterschicht 8 zu erkennen. Auf dieser sind dann auf ihrer absorberabgewandten Oberfläche die beiden Emitterkontakte 9 angeordnet.

Anhand von Figur 2a ist auch eine vorteilhafte Erweiterung der im Vergleich zum Stand der Technik vorgenommenen Modifikationen zu erkennen. Statt einer undotierten Capping-Schicht wird ein aus mindestens einer Teilschicht bestehendes Capping-Schichtsystem 4 auf der späteren Absorberschicht 3 abgeschieden. Mindestens eine Teilschicht aus diesem Capping-Schichtsystem (im gezeigten Fall besteht das Capping-Schicht-System 4 aus dieser Teilschicht) besitzt einen Anteil an Dotierstoff, der dem der Absorberschicht komplementär ist (der also n-Leitung verursacht, wenn die Absorberschicht p-leitend ist und umgekehrt). Im vorliegenden Fall bewirkt der Dotierstoff eine p-Leitung. Dieses Capping-Schichtsystem 4 wirkt nun während des Prozessschrittes 5 folgendermaßen: Im Schmelz-Teilprozess löst sich Dotierstoff aus dem Capping-Schichtsystem 4 heraus und verteilt sich in der Schmelze der späteren Absorberschicht 3 quasi homogen. Die Menge des herausgelösten bzw. in diese Schmelze eindiffundierenden Dotierstoffs kann durch un- oder schwachdotierte Teilschichten gesteuert werden, die auf der Seite der späteren Silizium-Absorberschicht 3 des Capping-Schichtsystems 4 liegen. Im Erstarrungs-Teilprozess des Prozessschritts 5 wird die Konzentration des Dotierstoffs aus dem Capping-Schichtsystems 4 in der späteren Absorberschicht 3 durch Segregationsprozesse eingestellt.

Die Segregation (dies ist ein Vorgang, bei dem sich ein Konzentrationsunterschied zwischen zwei angrenzenden Schichten einstellt, selbst wenn man sich im thermischen Gleichgewicht befindet. Segregation tritt z.B. für den Verunreinigungsstoff Eisen in Silizium extrem beim Erstarren auf: Die Konzentration im festen Silizium kann 10⁵ mal kleiner sein als im flüssigen) zwischen Flüssig- und Festphase kann durch Einstellen des Temperaturgradienten in der Schicht und damit der Richtung der Erstarrung gesteuert werden. Segregation tritt auch auf, wenn zwei unterschiedliche Materialien aneinander grenzen (beispielsweise SiO₂ und Si). Diese wird dann Festkörpersegregation genannt und kann dazu führen, dass im thermischen Gleichgewicht ein Konzentrationsgradient über zwei Festkörperschichten bestehen bleibt. Im erfindungsgemäßen Verfahren kann die Festkörpersegregation durch geschickt gewählte Schichtmaterialien für das Zwischenschichtsystem 2 und/oder das Capping-Schichtsystem 4 an der Grenzfläche zum Silizium bzw. zur Absorberschicht 3 ausgenutzt werden.

Im Temperschritt diffundiert weiter Dotierstoff aus der Capping-Multischicht 4 in die nun feste Absorberschicht 3. Aufgrund dieser Festkörperdiffusion bildet sich an der Oberfläche der Silizium-Schicht eine der Absorberschicht 3 gegendotierte Schicht, die als Solarzellenemitter bzw. Emitterschicht 8 (siehe Figur 2b) dient.

Die Konzentration des dritten Dotierstoffs in der Absorberschicht (der dritte Dotierstoff ist derjenige, der aus der dotierten Teilschicht des Capping-Schichtsystems 4 in die Absorberschicht 3 eindiffundiert) beträgt typischerweise für Silizium vor dem Aufschmelzen bzw. dem Rekristallisationsschritt zwischen 0 Atome/cm³ (undotiert) und etwa 10¹⁸ Atome/cm³ und nach dem Aufschmelzen bzw. dem Rekristallisationsschritt zwischen etwa 10¹⁷ und 10²² Atome/cm³, vorzugsweise zwischen 3x10¹⁸ und 2x10²¹ Atome/cm³. Die Konzentration des Dotierstoffs in der niedrig dotierten Absorberschicht bzw. im niedrig dotierten Bereich der Absorberschicht 3 beträgt vor dem Aufschmelzen bzw. dem Rekristallisationsschritt zwischen 0 Atome/cm³ (undotiert) und etwa 10¹⁷ Atome/cm³. Die entsprechende Konzentration nach dem Aufschmelzen bzw. dem Rekristallisationsschritt beträgt zwischen etwa 10¹⁴ Atome/cm³ und 10¹⁹ Atome/cm³. Optimal für Solarzellen ist eine Dotierstoffkonzentration (nach dem Aufschmelzen) von 10¹⁶ bis 5x10¹⁷ Atome/cm³.

Wird wie beschrieben ein Capping-Multischichtsystem 4 verwendet, so entfällt bei dem erfindungsgemäßen Herstellungsprozess ebenfalls die separate Herstellung des pn-Übergangs bzw. der Emitterschicht 8 (Prozessschritt 8 im Stand der Technik), d.h. die Herstellung des pn-Übergangs kann ebenfalls im Hochtemperaturschritt, in dem die Herstellung der BSF-Schicht erfolgt, erfolgen. Nach Entfernen der Capping-Multischicht 4 kann also unmittelbar mit der Metallisierung der Solarzelle begonnen werden.

Alternativ hierzu kann jedoch auch eine konventionelle Capping-Schicht 4 verwendet werden und der pn-Übergang analog zum Prozessschritt 8 des Standes der Technik hergestellt werden (durch Drucken, Sprühen oder Abscheiden einer mit Dotierstoff, welcher komplementär zum in der Absorberschicht 3 vorhandenen Dotierschicht ist, angereicherten Quellenschicht mit nachfolgendem oder gleichzeitigem Eintreiben dieses Dotierstoffs in die aktive Absorberschicht 3 durch Tempern).

Optional kann durch eine weitere Rekristallisierung der Emitter/Absorberschicht 3, 8, an der substratabgewandten Oberfläche bzw. der Emitterseite mit gezielter Einstellung der Dicke des verflüssigten Siliziums eine Emitterschicht hergestellt werden, welche eine Dicke aufweist, die die Dicke des Absorbers unterschreitet. Eine solche Emitterschicht hat typischerweise eine Dicke im Bereich von etwa 1 um.

Wesentliche Aspekte der vorliegenden Erfindung sind somit die Dotierung der Basisschicht bzw. Absorberschicht in der Schmelzphase durch Ausdiffusion aus dotierten, an der Basisschicht anliegenden Schichtsystemen und die gleichzeitig zu dieser Dotierung erfolgende Rekristallisierung der Absorberschicht und Herstellung der BSF-Schicht durch Diffusion aus einer Quellenschicht. Die beschriebenen Vorgänge erfolgen also in einem einzigen Hochtemperaturschritt.

Die Steuerung der Dotierung der Absorberschicht kann durch Anpassung der Rekristallisierungsgeschwindigkeit sowie der vorher und nachher stattfindenden Aufheiz-, Abkühl- und Temperprozesse geschehen. Die Steuerung der Dotierung der Absorberschicht kann jedoch auch durch Anpassung der Multischichtsysteme, d.h. des Capping-Multischichtsystems und/oder des Zwischenschicht-Multischichtsystems (in Bezug auf Anzahl und/oder Art der verwendeten Teilschichten, deren Dotierstoffgehalt und deren Dicke) erfolgen.

## Patentansprüche

1. Verfahren zur Herstellung eines dotierten Halbleiterschichtsystems für Elektronik oder Photovoltaik, wobei
in einem ersten Schritt eine Substratbasisschicht (1) hergestellt wird,
in einem zweiten Schritt auf dieser Substratbasisschicht (1) ein aus mindestens einer Teilschicht bestehendes Zwischenschichtsystem (2) abgeschieden wird, wobei mindestens eine der Teilschichten des Zwischenschichtsystems (2) mit einem ersten Dotierstoff in erster Konzentration angereichert wird,
in einem dritten Schritt eine undotierte oder mit einem zweiten Dotierstoff in zweiter Konzentration dotierte Absorberschicht (3) auf dem Zwischenschichtsystem (2) abgeschieden wird, und in einem Rekristallisationsschritt die Absorberschicht (3) aufgeheizt und zum Schmelzen gebracht sowie anschließend zum Erstarren abgekühlt wird,
**dadurch gekennzeichnet, dass**
die Absorberschicht (3) dotiert wird, indem der Rekristallisationsschritt so gesteuert wird oder indem so aufgeheizt, abgekühlt und getempert wird, dass erster Dotierstoff aus dem Zwischenschichtsystem (2) in die Absorberschicht (3) eindiffundiert, während diese geschmolzen ist und/oder während diese wieder erstarrt und/oder während diese erstarrt ist.

2. Herstellungsverfahren nach dem vorhergehenden Anspruch,
***dadurch gekennzeichnet, dass***
nach dem dritten Schritt und vor dem Rekristallisationsschritt eine undotierte Capping-Schicht (4) auf die Absorberschicht (3) aufgebracht wird und dass diese Capping-Schicht (4) nach dem Rekristallisationsschritt wieder entfernt wird.

3. Herstellungsverfahren nach Anspruch 1,
***dadurch gekennzeichnet, dass***
nach dem dritten Schritt und vor dem Rekristallisationsschritt ein aus mindestens einer Teilschicht bestehendes Capping-Schichtsystem (4) auf der Absorberschicht (3) aufgebracht wird, wobei mindestens eine der Teilschichten des Capping-SchicYitsystems (4) mit einem dritten Dotierstoff in dritter Konzentration angereichert wird.

4. Herstellungsverfahren nach dem vorhergehenden. Anspruch,
***dadurch gekennzeichnet, dass***
dieses Capping-Schichtsystem (4) nach dem Rekristallisationsschritt wieder entfernt wird.

5. Herstellungsverfahren nach einem der beiden vorhergehenden Ansprüche,
***dadurch gekennzeichnet, dass***
auf der substratabgewandten Seite des Halbleiterschichtsystems ein pn-Übergang bzw. eine Emitterschicht erzeugt wird, indem der Rekristallisationsschritt so gesteuert wird bzw. indem so aufgeheizt, abgekühlt und getempert wird, dass dritter Dotierstoff aus dem Capping-Schichtsystem (4) in die Absorberschicht (3) eindiffundiert während diese geschmolzen ist und/oder während diese wieder erstarrt und/oder während diese erstarrt ist.

6. Herstellungsverfahren nach dem vorhergehenden Anspruch,
***dadurch gekennzeichnet, dass***
die Menge des eindiffundierten dritten Dotierstoffs mit Hilfe von auf der der Absorberschicht (3) zugewandten Seite liegenden, un- oder schwach dotierten Teilschichten des Capping-Schichtsystems (4) gesteuert wird.

7. Herstellungsverfahren nach einem der beiden vorhergehenden Ansprüche oder nach Anspruch 1,
***dadurch gekennzeichnet, dass***
die Menge des dritten und/oder die Menge des ersten Dotierstoffs, die in die Absorberschicht (3) eindiffundiert während diese erstarrt und/oder erstarrt ist, durch Segregationsprozesse eingestellt wird.

8. Herstellungsverfahren nach einem der Ansprüche 1 bis 2,
***dadurch gekennzeichnet, dass***
auf der substratabgewandten oder der substratzugewandten Seite des Halbleiterschichtsystems oder der Absorberschicht (3) ein pn-Übergang bzw. eine Emitterschicht erzeugt wird, in dem ein dritter, zum ersten und zweiten Dotierstoff komplementärer Dotierstoff in die Absorberschicht (3) eingetrieben wird.

9. Herstellungsverfahren nach einem der vorhergehenden Ansprüche,
**dadurch gekennzeichnet, dass**
der zweite Dotierstoff zum ersten Dotierstoff komplementär ist oder dass der zweite Dotierstoff zum ersten Dotierstoff nicht komplementär ist.

10. Herstellungsverfahren nach einem der vorhergehenden Ansprüche,
**dadurch gekennzeichnet, dass**
der erste und der zweite Dotierstoff identisch sind.

11. Herstellungsverfahren nach einem der vorhergehenden Ansprüche und nach Anspruch 3,
**dadurch gekennzeichnet, dass**
der dritte Dotierstoff zum zweiten Dotierstoff komplementär ist oder dass der dritte Dotierstoff zum zweiten Dotierstoff nicht komplementär ist.

12. Herstellungsverfahren nach einem der vorhergehenden Ansprüche und nach Anspruch 3,
**dadurch gekennzeichnet, dass**
der zweite und der dritte Dotierstoff identisch sind.

13. Herstellungsverfahren nach einem der vorhergehenden Ansprüche und nach Anspruch 3,
**dadurch gekennzeichnet, dass**
der zweite Dotierstoff komplementär zum ersten und dritten Dotierstoff ist oder dass der erste Dotierstoff komplementär zum zweiten und dritten Dotierstoff ist oder dass der dritte Dotierstoff komplementär zum ersten und zweiten Dotierstoff ist.

14. Herstellungsverfahren nach einem der vorhergehenden Ansprüche,
**dadurch gekennzeichnet, dass**
die Absorberschicht (3) so komplementär zum Zwischenschichtsystem (2) dotiert wird, dass die Komplementär-Dotierung im Rekristallisationsschritt überdotiert wird.

15. Herstellungsverfahren nach einem der vorhergehenden Ansprüche,
**dadurch gekennzeichnet, dass**
die Schichtdicke mindestens einer Teilschicht des Zwischenschichtsystems (2) über 10 nm und/oder unter 10000 nm, insbesondere über 100 nm und/oder unter 1000 nm beträgt und/oder dass das Zwischenschichtsystem Verbindungen aus Si, O, C, N, B, P, Al, Ga, Sb, As und/oder In, insbesondere SiO₂, SiNₓ, SiC, BC und/oder BN, enthält oder daraus besteht und/oder dass das Zwischenschichtsystem (2) leitfähig ist.

16. Herstellungsverfahren nach einem der vorhergehenden Ansprüche und nach Anspruch 3,
**dadurch gekennzeichnet, dass**
die Schichtdicke mindestens einer Teilschicht des Capping-Schichtsystems (4) über 10 nm und/oder unter 10000 nm, insbesondere über 100. nm und/oder unter 1000 nm beträgt und/oder dass das Capping-Schichtsystem Verbindungen aus Si, O, C, N, B, P, Al, Ga, Sb, As und/oder In, insbesondere SiO₂, SiNₓ, SiC, BC und/oder BN, enthält oder daraus besteht.

17. Herstellungsverfahren nach einem der vorhergehenden Ansprüche,
**dadurch gekennzeichnet, dass**
im Rekristallisationsschritt getempert wird.

18. Herstellungsverfahren nach einem der vorhergehenden Ansprüche,
**dadurch gekennzeichnet, dass**
über die Heizleistung und/oder die Verteilung der Heizleistung und/oder die Vorschubgeschwindigkeit und/oder mindestens eine Aufheizrampe und/oder mindestens eine Abkühlrampe und/oder die Temperatur eines Temperplateaus und/oder über eine Temperzeit gesteuert wird.

19. Herstellungsverfahren nach einem der vorhergehenden Ansprüche und nach Anspruch 6,
**dadurch gekennzeichnet, dass**
über die Temperatur und/oder eine Temperzeit bzw. durch das Temperaturprofil über der Zeit gesteuert wird.

20. Herstellungsverfahren nach einem der vorhergehenden Ansprüche und nach Anspruch 7,
**dadurch gekennzeichnet, dass**
die Einstellung über einen Temperaturgradienten in der Absorberschicht (3) und/oder in dem Capping-Schichtsystem (4) und/oder zwischen der Absorberschicht (3) und dem Capping-Schichtsystem (4) erfolgt.

21. Herstellungsverfahren nach einem der vorhergehenden Ansprüche und nach Anspruch 8,
***dadurch gekennzeichnet, dass***
der pn-Übergang bzw. die Emitterschicht erzeugt wird, indem eine mit dem dritten Dotierstoff angereicherte Quellenschicht auf die Absorberschicht (3) aufgebracht, aufgedruckt, aufgesprüht oder auf der Absorberschicht (3) abgeschieden wird und anschließend oder gleichzeitig der dritte Dotierstoff in die Absorberschicht (3) durch Tempern eingetrieben wird.

22. Herstellungsverfahren nach einem der vorhergehenden Ansprüche,
***dadurch gekennzeichnet, dass***
die zweite Konzentration so gewählt wird, dass sie gleich oder niedriger ist, wie die nach Abschluss des Herstellungsverfahrens in der Absorberschicht (3) zu erzielende Dotierstoffkonzentration.

23. Herstellungsverfahren nach einem der vorhergehenden Ansprüche,
***dadurch gekennzeichnet, dass***
die Dotierung der Absorberschicht (3) über die Rekristallisationsgeschwindigkeit und/oder -temperatur gesteuert wird.

24. Herstellungsverfahren nach einem der vorhergehenden Ansprüche,
***dadurch gekennzeichnet, dass***
die Dotierung der Absorberschicht (3) gesteuert wird über die Anzahl, die Dicke und/oder den Dotierstoffgehalt der einzelnen Schichten des Capping-Schichtsystems (4) und/oder des Zwischenschichtsystems (2).

25. Herstellungsverfahren nach einem der vorhergehenden Ansprüche,
***dadurch gekennzeichnet, dass***
in einem der Substratbasis (1) zugewandten Teil der Absorberschicht (3) eine Schicht mit einer höheren Konzentration an Dotierstoff als in der restlichen Absorberschicht (3), insbesondere eine BSF-Schicht (Back-Surface-Field), ausgebildet wird, indem der Rekristallisationsschritt so gesteuert wird bzw. indem so aufgeheizt, abgekühlt und getempert wird, dass erster Dotierstoff aus dem Zwischenschichtsystem (2) in die Absorberschicht (3) eindiffundiert, während diese geschmolzen ist und/oder während diese wieder erstarrt und/oder während diese erstarrt ist.

26. Herstellungsverfahren nach einem der vorhergehenden Ansprüche,
***dadurch gekennzeichnet, dass***
durch einen zusätzlichen Rekristallisierungsschritt die Absorberschicht (3) an ihrer substratabgewandten Seite in einem definierten Dickenbereich aufgeschmolzen wird.

27. Herstellungsverfahren nach dem vorhergehenden Anspruch,
***dadurch gekennzeichnet, dass***
der aufgeschmolzene Dickenbereich kleiner ist als die Dicke der Absorberschicht (3) und/oder dass eine Emitterschicht, insbesondere mit einer Dicke von über 0.1 µm und/oder unter 10 µm, hergestellt wird.

28. Herstellungsverfahren nach einem der vorhergehenden Ansprüche und nach einem der Ansprüche 2 oder 3,
***dadurch gekennzeichnet, dass***
die Konzentration des dritten Dotierstoffs in der Absorberschicht (3) vor dem Rekristallisationsschritt bzw. dem Aufschmelzen über 0 Atome/cm³ und/oder unter 10¹⁸ Atome/cm³ beträgt und/oder dass diese Konzentration nach dem Rekristallisationsschritt bzw. dem Aufschmelzen über 10¹⁶Atome/cm³ und/oder unter 10²³ Atome/cm³ insbesondere über 3•10¹⁸ und/oder unter 2•10²¹ Atome/cm³, beträgt.

29. Herstellungsverfahren nach einem der vorhergehenden Ansprüche,
***dadurch gekennzeichnet, dass***
die Konzentration des ersten Dotierstoffs im Zwischenschichtsystem (2) vor dem Rekristallisationsschritt bzw. dem Aufschmelzen über 0 Atome/cm³ und/oder unter 10²³ Atome/cm³ beträgt und/oder dass diese Konzentration nach dem Rekristallisationsschritt bzw. dem Aufschmelzen über 10¹⁶ Atome/cm³ beträgt.

30. Herstellungsverfahren nach einem der vorhergehenden Ansprüche,
***dadurch gekennzeichnet, dass***
die Konzentration des zweiten Dotierstoffs in der Absorberschicht (3) vor dem Rekristallisationsschritt bzw. dem Aufschmelzen über 0 Atome/cm³ und/oder unter 10¹⁷ Atome/cm³ beträgt und/oder dass diese Konzentration nach dem Rekristallisationsschritt bzw. dem Aufschmelzen über 10¹⁴ Atome/cm³ und/oder unter 10¹⁹ Atome/cm³, insbesondere über 10¹⁶ Atome/cm³ und/oder unter 5•10¹⁷ Atome/cm³ beträgt.

31. Herstellungsverfahren nach einem der vorhergehenden Ansprüche,
***dadurch gekennzeichnet, dass***
der erste und der zweite Dotierstoff eine n-Leitung hervorrufen (n⁺np-System) und dass der dritte Dotierstoff eine p-Leitung hervorruft oder dass umgekehrt der erste und der zweite Dotierstoff eine p-Leitung hervorrufen und dass der dritte Dotierstoff eine n-Leitung hervorruft (p⁺pn-System) oder dass der erste und der dritte Dotierstoff eine n-Leitung hervorrufen und dass der zweite Dotierstoff eine p-Leitung hervorruft (npn-System) oder umgekehrt (pnp-System) oder dass der zweite und der dritte Dotierstoff eine n-Leitung hervorrufen und dass der erste Dotierstoff eine p-Leitung hervorruft (pnn⁺-System) oder umgekehrt (npp⁺-System).

32. Herstellungsverfahren nach einem der vorhergehenden Ansprüche,
***dadurch gekennzeichnet, dass***
auf die Substratbasisschicht (1) und/oder auf die Absorberschicht (3) eine metallische Kontaktschicht bzw. eine Metallisierung aufgebracht wird.

33. Herstellungsverfahren nach dem vorhergehenden Anspruch und nach einem der Ansprüche 5 oder 8,
***dadurch gekennzeichnet, dass***
ein Emitterkontakt auf der Emitterschicht aufgebracht wird.

34. Herstellungsverfahren nach einem der vorhergehenden Ansprüche,
***dadurch gekennzeichnet, dass***
die Substratbasisschicht (1) und/oder die Absorberschicht (3) Silizium (Si) enthält und/oder leitfähig ist.

35. Herstellungsverfahren nach einem der vorhergehenden Ansprüche und nach Anspruch 2 oder 3,
***dadurch gekennzeichnet, dass***
die Capping-Schicht (4) bzw. das Capping-Schichtsystem (4) durch Abscheiden oder durch thermisches Oxidieren hergestellt wird.

36. Verwendung eines Herstellungsverfahrens nach einem der vorhergehenden Ansprüche im Bereich der Herstellung von elektronischen Bauteilen, insbesondere in der Silicon-on-Insulator Technologie, oder zur Herstellung von oder im Bereich von Dünnschichtsolarzellen, insbesondere von kristallinen Silizium-Dünnschichtsolarzellen.

37. Halbleiterschichtsystem, insbesondere Dünnschichtsolarzelle oder kristalline Dünnschichtsolarzelle auf Siliziumbasis, hergestellt durch ein Herstellungsverfahren nach einem der Ansprüche 1 bis 35.

## Claims

1. Method for the production of a doped semiconductor layer system for electronics or photovoltaics, wherein
in a first step, a substrate base layer (1) is produced,
in a second step, on this substrate base layer (1) an intermediate layer system (2) comprising at least one partial layer is deposited, at least one of the partial layers of the intermediate layer system (2) being enriched with a first dopant in a first concentration,
in a third step, an absorber layer (3) which is undoped or doped with a second dopant in a second concentration is deposited on the intermediate layer system (2), and
in a recrystallisation step, the absorber layer (3) is heated and brought to melt and is cooled subsequently in order to solidify,
***characterised in that***
the absorber layer (3) is doped by controlling the recrystallisation step such or by heating, cooling and tempering such that the first dopant diffuses out of the intermediate layer system (2) into the absorber layer (3), while the latter is molten and/or while the latter is resolidifying and/or while the latter has solidified.

2. Production method according to the preceding claim,
***characterised in that**,*
after the third step and before the recrystallisation step, an undoped capping layer (4) is applied on the absorber layer (3) and **in that** this capping layer (4) is removed again after the recrystallisation step.

3. Production method according to claim 1,
***characterised in that**,*
after the third step and before the recrystallisation step, a capping layer system (4) comprising at least one partial layer is applied on the absorber layer (3), at least one of the partial layers of the capping layer system (4) being enriched with a third dopant in a third concentration.

4. Production method according to the preceding claim,
***characterised in that***
this capping layer system (4) is removed again after the recrystallisation step.

5. Production method according to one of the two preceding claims,
***characterised in that**,*
on the side of the semiconductor layer system orientated away from the substrate, a pn transition or an emitter layer is produced by controlling the recrystallisation step such or by heating, cooling and tempering such that the third dopant is diffused out of the capping layer system (4) into the absorber layer (3) while the latter is molten and/or while the latter is resolidifying and/or while the latter has solidified.

6. Production method according to the preceding claim,
***characterised in that***
the quantity of the inwardly diffused third dopant is controlled with the help of partial layers of the capping layer system (4) which are situated on the side orientated towards the absorber layer (3) and are undoped or weakly doped.

7. Production method according to one of the two preceding claims or according to claim 1,
***characterised in that***
the quantity of the third and/or the quantity of the first dopant which diffuses into the absorber layer (3) while the latter is solidifying and/or has solidified is adjusted by segregation processes.

8. Production method according to one of the claims 1 to 2,
***characterised in that**,*
on the side of the semiconductor layer system or of the absorber layer (3) which is orientated away from the substrate or towards the substrate, a pn transition or an emitter layer is produced by introducing a third dopant which is complementary to the first and the second dopant into the absorber layer (3).

9. Production method according to one of the preceding claims,
***characterised in that***
the second dopant is complementary to the first dopant or **in that** the second dopant is not complementary to the first dopant.

10. Production method according to one of the preceding claims,
***characterised in that***
the first and the second dopant are identical.

11. Production method according to one of the preceding claims and according to claim 3,
***characterised in that***
the third dopant is complementary to the second dopant or **in that** the third dopant is not complementary to the second dopant.

12. Production method according to one of the preceding claims and according to claim 3,
***characterised in that***
the second and the third dopant are identical.

13. Production method according to one of the preceding claims and according to claim 3,
***characterised in that***
the second dopant is complementary to the first and to the third dopant or **in that** the first dopant is complementary to the second and to the third dopant or **in that** the third dopant is complementary to the first and to the second dopant.

14. Production method according to one of the preceding claims,
***characterised in that***
the absorber layer (3) is doped complementarily to the intermediate layer system (2) such that the complementary doping is over-doped in the recrystallisation step.

15. Production method according to one of the preceding claims,
***characterised in that***
the layer thickness at least of one partial layer of the intermediate layer system (2) is above 10 nm and/or below 10000 nm, in particular above 100 nm and/or below 1000 nm, and/or **in that** the intermediate layer system comprises or consists of compounds of Si, O, C, N, B, P, Al, Ga, Sb, As and/or In, in particular SiO₂ SiNₓ, SiC, BC and/or BN, and/or **in that** the intermediate layer system (2) is conductive.

16. Production method according to one of the preceding claims and according to claim 3,
***characterised in that***
the layer thickness at least of one partial layer of the capping layer system (4) is above 10 nm and/or below 10000 nm, in particular above 100 m and/or below 1000 nm, and/or **in that** the capping layer system comprises or consists of compounds of Si, O, C, N, B, P, Al, Ga, Sb, As and/or In, in particular SiO₂, SiNₓ, SiC, BC and/or BN.

17. Production method according to one of the preceding claims,
***characterised in that***
tempering takes place in the recrystallisation step.

18. Production method according to one of the preceding claims,
***characterised in that***
control takes place via the heating power and/or the distribution of the heating power and/or the feed rate and/or at least one heating ramp and/or at least one cooling ramp and/or the temperature of a tempering plateau and/or via a tempering time.

19. Production method according to one of the preceding claims and according to claim 6,
***characterised in that***
control takes place via the temperature and/or tempering time or by the temperature profile over time.

20. Production method according to one of the preceding claims and according to claim 7,
***characterised in that***
the adjustment is effected over a temperature gradient in the absorber layer (3) and/or in the capping layer system (4) and/or between the absorber layer (3) and the capping layer system (4).

21. Production method according to one of the preceding claims and according to claim 8,
***characterised in that***
the pn transition or the emitter layer is produced **in that** a source layer enriched with the third dopant is applied to the absorber layer (3), printed on, sprayed on or deposited on the absorber layer (3) and subsequently or simultaneously the third dopant is introduced into the absorber layer (3) by tempering.

22. Production method according to one of the preceding claims,
***characterised in that***
the second concentration is chosen such that it is the same or lower than the dopant concentration to be achieved in the absorber layer (3) after conclusion of the production method.

23. Production method according to one of the preceding claims,
***characterised in that***
the doping of the absorber layer (3) is controlled via the recrystallisation speed and/or recrystallisation temperature.

24. Production method according to one of the preceding claims,
***characterised in* that**
the doping of the absorber layer (3) is controlled via the number, the thickness and/or the dopant content of the individual layers of the capping layer system (4) and/or of the intermediate layer system (2).

25. Production method according to one of the preceding claims,
***characterised in that**,*
in a part of the absorber layer (3) which is orientated towards the substrate base (1), a layer with a higher concentration of dopant than in the remaining absorber layer (3), in particular a BSF layer (back surface field), is formed by controlling the recrystallisation step such or by heating, cooling and tempering such that the first dopant diffuses out of the intermediate layer system (2) into the absorber layer (3) while the latter is molten and/or while the latter is resolidifying and/or while the latter has solidified.

26. Production method according to one of the preceding claims,
***characterised in that**,*
as a result of an additional recrystallisation step, the absorber layer (3) is melted on the side thereof orientated away from the substrate in a defined thickness region.

27. Production method according to the preceding claim,
***characterised in that***
the molten thickness region is smaller than the thickness of the absorber layer (3) and/or **in that** an emitter layer is produced in particular with a thickness of above 0.1 µm and/or below 10 µm.

28. Production method according to one of the preceding claims and according to one of the claims 2 or 3,
***characterised in that***
the concentration of the third dopant in the absorber layer (3) before the recrystallisation step or the melting is above 0 atoms/cm³ and/or below 10¹⁸ atoms/cm³ and/or **in that** this concentration after the recrystallisation step or the melting is above 10¹⁶ atoms/cm³ and/or below 10²³ atoms/cm³, in particular above 3•10¹⁸ and/or below 2•10²¹ atoms/cm³.

29. Production method according to one of the preceding claims,
***characterised in that***
the concentration of the first dopant in the intermediate layer system (2) before the recrystallisation step or the melting is above 0 atoms/cm³ and/or below 10²³ atoms/cm³ and/or **in that** this concentration after the recrystallisation step or the melting is above 10¹⁶ atoms/cm³.

30. Production method according to one of the preceding claims,
***characterised in that***
the concentration of the second dopant in the absorber layer (3) before the recrystallisation step or the melting is above 0 atoms/cm³ and/or below 10¹⁷ atoms/cm³ and/or **in that** this concentration after the recrystallisation step or the melting is above 10¹⁴ atoms/cm³ and/or below 10¹⁹ atoms/cm³, in particular above 10¹⁶ atoms/cm³ and/or below 5•10¹⁷ atoms/cm³ .

31. Production method according to one of the preceding claims,
***characterised in that***
the first and the second dopant cause an n conductivity (n⁺np system) and **in that** the third dopant causes a p conductivity or **in that** vice versa the first and the second dopant cause a p conductivity and **in that** the third dopant causes an n conductivity (p⁺pn system) or **in that** the first and the third dopant cause an n conductivity and **in that** the second dopant causes a p conductivity (npn system) or vice versa (pnp system) or **in that** the second and the third dopant cause an n conductivity and **in that** the first dopant causes a p conductivity (pnn⁺ system) or vice versa (npp⁺ system).

32. Production method according to one of the preceding claims,
***characterised in that***
a metallic contact layer or a metallisation is applied on the substrate base layer (1) and/or on the absorber layer (3).

33. Production method according to the preceding claim and according to one of the claims 5 or 8,
***characterised in that***
an emitter contact is applied on the emitter layer.

34. Production method according to one of the preceding claims,
***characterised in that***
the substrate base layer (1) and/or the absorber layer (3) contains silicon (Si) and/or is conductive.

35. Production method according to one of the preceding claims and according to claim 2 or 3,
***characterised in that***
the capping layer (4) or the capping layer system (4) is produced by deposition or by thermal oxidation.

36. Use of a production method according to one of the preceding claims in the field of the production of electronic components, in particular in silicon-on-insulator technology, or for the production of or in the field of thin layer solar cells, in particular crystalline silicon thin layer solar cells.

37. Semiconductor layer system, in particular thin layer solar cell or crystalline thin layer solar cell based on silicon, produced by a production method according to one of the claims 1 to 35.

## Revendications

1. Procédé de fabrication d'un système de couches semi-conductrices dopées pour l'électronique ou le photovoltaïque, dans lequel :
dans une première étape, on fabrique une couche de base de substrat (1),
dans une deuxième étape, un système de couches intermédiaires (2), constitué d'au moins une couche partielle, se forme, par procédé de dépôt, sur la couche de base de substrat (1), dans laquelle étape au moins une des couches partielles du système de couches intermédiaires (2) est enrichie en élément dopant d'un premier type et dans une première concentration,
dans une troisième étape, une couche absorbante (3) non dopée ou enrichie en élément dopant d'un deuxième type et dans une deuxième concentration se forme, par procédé de dépôt, sur le système de couches intermédiaires (2), et
dans l'étape de recristallisation, la couche absorbante (3) est chauffée et fondue, puis refroidie jusqu'à sa solidification,
**caractérisé en ce que**
la couche absorbante (3) est dopée par l'étape de recristallisation ou le procédé de chauffage, de refroidissement et de revenu, pilotés de telle sorte que l'élément dopant du premier type migre par diffusion du système de couches intermédiaires (2), dans la couche absorbante (3) pendant que celle-ci est fondue et/ou pendant que celle-ci est en phase de resolidification et/ou pendant que celle-ci est s'est solidifiée.

2. Procédé de fabrication selon la revendication précédente,
**caractérisé en ce que**,
après la troisième étape et avant l'étape de recristallisation, une couche de protection non dopée (4) est déposée sur la couche absorbante (3) et **en ce que** cette couche de protection (4) est à nouveau retirée après l'étape de recristallisation.

3. Procédé de fabrication selon la revendication 1,
**caractérisé en ce que**,
après la troisième étape et avant l'étape de recristallisation, un système de couches de protection (4) constitué d'au moins une couche partielle est déposé sur la couche absorbante (3), au moins l'une des couches partielles du système de couches de protection (4) étant enrichie en élément dopant d'un troisième type dans une troisième concentration.

4. Procédé de fabrication selon la revendication précédente,
**caractérisé en ce que**
ce système de couches de protection (4) est à nouveau retiré après l'étape de recristallisation.

5. Procédé de fabrication selon l'une quelconque des deux revendications précédentes,
**caractérisé en ce que**,
sur la face des couches semi-conductrices qui est opposée au substrat, on génère une jonction pn, c'est-à-dire une couche émettrice, en pilotant l'étape de recristallisation ou le procédé de chauffage, de refroidissement et de trempage, de telle sorte que l'élément dopant du troisième type migre par diffusion du système des couches protectrices (4), dans la couche absorbante (3) pendant que celle-ci est fondue et/ou pendant que celle-ci est en phase de resolidification et/ou pendant que celle-ci est s'est solidifiée.

6. Procédé de fabrication selon la revendication précédente,
**caractérisé en ce que**
la quantité du troisième élément dopant incorporé par diffusion est dosée à l'aide des couches partielles non dopées ou faiblement dopées du système des couches protectrices (4), qui sont tournées vers la couche absorbante (3).

7. Procédé de fabrication selon l'une quelconque des deux revendications précédentes ou selon la revendication 1,
**caractérisé en ce que**
l'on règle par des procédés de séparation la quantité du troisième élément dopant et /ou la quantité du premier élément dopant, qui entre par diffusion dans la couche absorbante (3), pendant que celle-ci est en cours de solidification et/ou pendant que celle-ci est s'est solidifié.

8. Procédé de fabrication selon l'une quelconque des revendications 1 à 2,
**caractérisé en ce que**,
au niveau du système des couches semi-conductrices ou de la couche absorbante (3), sur la face qui est opposée substrat ou sur celle qui est tournée vers le substrat, on génère une jonction pn, respectivement une couche émettrice, en implantant, dans la couche absorbante (3) un élément dopant d'un troisième type qui est complémentaire des premier et deuxième éléments dopants.

9. Procédé de fabrication selon l'une quelconque des revendications précédentes,
**caractérisé en ce que**
le deuxième élément dopant est complémentaire du premier élément dopant ou **en ce que** le deuxième élément dopant n'est pas complémentaire du premier élément dopant.

10. Procédé de fabrication selon l'une quelconque des revendications précédentes,
**caractérisé en ce que**
les premier et deuxième éléments dopants sont identiques.

11. Procédé de fabrication selon l'une quelconque des revendications précédentes et selon la revendication 3,
**caractérisé en ce que**
le troisième élément dopant est complémentaire du deuxième élément dopant ou **en ce que** le troisième élément dopant n'est pas complémentaire du deuxième élément dopant.

12. Procédé de fabrication selon l'une quelconque des revendications précédentes ou selon la revendication 3,
**caractérisé en ce que**
le deuxième et le troisième éléments dopants sont identiques.

13. Procédé de fabrication selon l'une quelconque des revendications précédentes et selon la revendication 3,
**caractérisé en ce que**
le deuxième élément dopant est complémentaire du premier et du troisième éléments dopants ou **en ce que** le premier élément dopant est complémentaire du deuxième et du troisième éléments dopants ou **en ce que** le troisième élément dopant est complémentaire du premier et du deuxième élément dopant.

14. Procédé de fabrication selon l'une quelconque des revendications précédentes,
**caractérisé en ce que**
la couche absorbante (3) est soumise à un dopage complémentaire par rapport au système de couches intermédiaires (2) tel que pendant l'étape de recristallisation, un surdopage se forme au niveau du dopage complémentaire.

15. Procédé de fabrication selon l'une quelconque des revendications précédentes,
**caractérisé en ce que**
l'épaisseur d'au moins une couche partielle du système des couches intermédiaires (2) est supérieure à 10 nm et/ou inférieure à 10 000 nm, en particulier supérieure à 100 nm et/ou inférieure à 1000 nm et/ou **en ce que** le système de couches intermédiaires contient des composés choisis parmi les éléments Si, O, C, N, B, P, Al, Ga, Sb, As et/ou In, en particulier les composés. SiO₂, SiNₓ, Sic, du BC et/ou du BN, ou en est constitué et/ou **en ce que** le système de couches intermédiaires (2) est conducteur.

16. Procédé de fabrication selon l'une quelconque des revendications précédentes et selon la revendication 3,
**caractérisé en ce que**
l'épaisseur d'au moins une couche partielle du système de couches de protection (4) est supérieure à 10 nm et/ou inférieure à 10 000 nm, en particulier supérieure à 100 nm et/ou inférieure à 1000 nm, et/ou **en ce que** le système de couches de protection contient des composés choisis parmi les éléments Si, O, C, N, B, P, Al, Ga, Sb, As et/ou In, en particulier les composés SiO₂, SiNₓ, SiC, BC et/ou BN, ou en est constitué.

17. Procédé de fabrication selon l'une quelconque des revendications précédentes,
**caractérisé en ce que**
l'on effectue un revenu à l'étape de recristallisation.

18. Procédé de fabrication selon l'une quelconque des revendications précédentes,
**caractérisé en ce que**
il est piloté par l'intermédiaire de la puissance de chauffage et/ou de la répartition de la puissance de chauffage et/ou de la vitesse d'avancement et/ou d'au moins une rampe de chauffage et/ou d'au moins une rampe de refroidissement et/ou de la température d'un plateau de trempage et/ou par l'intermédiaire d'une durée de revenu donnée.

19. Procédé de fabrication selon l'une quelconque des revendications précédentes et selon la revendication 6,
**caractérisé en ce qu'**
il est piloté par l'intermédiaire de la température et/ou d'une durée de revenu donnée, c'est-à-dire par le biais du profil de température en fonction du temps.

20. Procédé de fabrication selon l'une quelconque des revendications précédentes et selon la revendication 7,
**caractérisé en ce que**
le réglage s'effectue par le biais d'un gradient de température existant au sein de la couche absorbante (3) et/ou du système de couches de protection (4) et/ou entre la couche absorbante (3) et le système de couches de protection (4).

21. Procédé de fabrication selon l'une quelconque des revendications précédentes et selon la revendication 8,
**caractérisé en ce que**
la jonction pn, respectivement la couche émettrice, est générée par l'application, l'impression ou la pulvérisation d'une couche source, enrichie en élément dopant du troisième type, sur la couche absorbante (3) ou par sa formation de dépôt sur la couche absorbante (3) et ensuite ou simultanément par l'implantation de l'élément dopant du troisième type dans la couche absorbante (3), réalisée par revenu.

22. Procédé de fabrication selon l'une quelconque des revendications précédentes,
**caractérisé en ce que**
l'on choisit la deuxième concentration de sorte qu'elle soit égale ou inférieure à la concentration cible de l'élément dopant à l'issue du procédé de fabrication au sein de la couche absorbante (3).

23. Procédé de fabrication selon l'une quelconque des revendications précédentes,
**caractérisé en ce que**
le dopage de la couche absorbante (3) est piloté par l'intermédiaire de la vitesse et/ou de la température de recristallisation.

24. Procédé de fabrication selon l'une quelconque des revendications précédentes,
**caractérisé en ce que**
le dopage de la couche absorbante (3) est piloté par l'intermédiaire du nombre, de l'épaisseur et/ou de la teneur en élément dopant des différentes couches du système de couches de protection (4) et/ou du système de couches intermédiaires (2).

25. Procédé de fabrication selon l'une quelconque des revendications précédentes,
**caractérisé en ce que**
dans une partie de la couche absorbante (3) qui est tournée vers la base de substrat (1), une couche ayant une concentration plus élevée en élément dopant que le reste de la couche absorbante (3), en particulier une couche de type BSF (Back-Surface-Field), se forme quand on pilote la phase de recristallisation, c'est-à-dire que l'on met en oeuvre le chauffage, le refroidissement et le revenu, de telle sorte que l'élément dopant du premier type migre par diffusion du système de couches intermédiaires (2) dans la couche absorbante (3), pendant que cette dernière est fondue et/ ou pendant que cette dernière est en phase de resolidification et/ou pendant que celle-ci est s'est resolidifiée.

26. Procédé de fabrication selon l'une quelconque des revendications précédentes,
**caractérisé en ce que**,
dans une étape de recristallisation supplémentaire, on fait fondre, dans une plage d'épaisseur définie, la couche absorbante (3) au niveau de la face opposée au substrat.

27. Procédé de fabrication selon la revendication précédente,
**caractérisé en ce que**
la plage d'épaisseur définie, qui a été fondue, est inférieure à l'épaisseur de la couche absorbante (3) et/ou **en ce qu'**une couche émettrice est générée, qui est, de préférence, d'une épaisseur supérieure à 0,1 µm et/ou inférieure à 10 µm,

28. Procédé de fabrication selon l'une quelconque des revendications précédentes et selon l'une quelconque des revendications 2 ou 3,
**caractérisé en ce que**
la concentration de l'élément dopant du troisième type dans la couche absorbante (3) est, avant l'étape de recristallisation, c'est-à-dire avant l'opération de fusion, supérieure à 0 atome/cm³ et/ou inférieure à 10¹⁸ atomes/cm³ et/ou **en ce que** cette concentration est, après l'étape de recristallisation c'est-à-dire après l'opération de fusion, supérieure à 10¹⁶ atomes/cm³ et/ou inférieure à 10²³ atomes/cm³, de préférence supérieure à 3•10¹⁸ g et/ou inférieure à 2•10²¹ atomes/cm³.

29. Procédé de fabrication selon l'une quelconque des revendications précédentes,
**caractérisé en ce que**
la concentration de l'élément dopant du premier type dans le système de couches intermédiaires (2) est, avant l'étape de recristalllisation, respectivement avant l'opération de fusion, supérieure à 0 atome/cm³ et/ou inférieure à 10²³ atomes/cm³ et/ou **en ce que** cette concentration est, après l'étape de recristallisation c'est-à-dire après l'opération de fusion, supérieure à 10¹⁶ atomes/cm³.

30. Procédé de fabrication selon l'une quelconque des revendications précédentes,
**caractérisé en ce que**
la concentration de l'élément dopant du deuxième type dans la couche absorbante (3) est, avant l'étape de recristallisation, respectivement avant l'opération de fusion, supérieure à 0 atome/cm³ et/ou inférieure à 10¹⁷ atomes/cm³ et/ou **en ce que** cette concentration est, après l'étape de recristallisation, respectivement après l'opération de fusion, supérieure à 10¹⁴ atomes/cm³ et/ou inférieure à 10¹⁹ atomes/cm³, de préférence supérieure à 10¹⁶ atomes/cm³ et/ou inférieure à 5•10¹⁷ atomes/cm³.

31. Procédé de fabrication selon l'une quelconque des revendications précédentes,
**caractérisé en ce que**
les éléments dopants du premier et du deuxième type provoquent une conduction de type n (système de type n⁺np) et l'élément dopant du troisième type provoque une conduction de type p ou **en ce qu'**inversement, les éléments dopants du premier et du deuxième type provoquent une conduction de type p et l' élément dopant du troisième type provoque une conduction de type n (système de type p⁺pn) ou **en ce que** les éléments dopants du premier et du troisième type provoquent une conduction de type n et l'élément dopant du deuxième type provoque une conduction de type p (système de type npn) ou l'inverse (système de type pnp) ou **en ce que** les éléments dopants du deuxième et du troisième type provoquent une conduction de type n et l'élément dopant du premier type provoque une conduction de type p (système de type pnn⁺) ou l'inverse (système de type npp⁺).

32. Procédé de fabrication selon l'une quelconque des revendications précédentes,
**caractérisé en ce que**
l'on fixe une couche de contact métallique sur la couche de base de substrat (1) et/ou sur la couche absorbante (3), ou on les métallise.

33. Procédé de fabrication selon la revendication précédente et selon l'une quelconque des revendications 5 ou 8,
**caractérisé en ce que**
un contact émetteur est appliqué sur la couche émettrice.

34. Procédé de fabrication selon l'une quelconque des revendications précédentes,
**caractérisé en ce que**
la couche de base de substrat (1) et/ou la couche absorbante (3) contient ou contiennent du silicium (Si) et/ou est ou sont conductrices.

35. Procédé de fabrication selon l'une quelconque des revendications précédentes et selon la revendication 2 ou 3,
**caractérisé en ce que**
la couche de protection (4), c'est-à-dire le système de couches de protection (4) est produit(e) par procédé de dépôt ou par oxydation thermique.

36. Utilisation d'un procédé de fabrication selon l'une quelconque des revendications précédentes dans le secteur de la fabrication de composants électroniques, en particulier dans le cadre de la technologie SOI (Silicon-on-Insulator), ou bien pour la fabrication de cellules solaires à couches minces, ou bien une utilisation dans ce contexte, et en particulier de cellules solaires à couches minces de silicium empilées sur une couche silicium cristallin.

37. Système de couches semi-conductrices, en particulier des cellules solaires à couches minces ou des cellules solaires à couches minces sur couche cristalline qui sont à base de silicium, fabriqué dans un procédé de fabrication selon l'une quelconque des revendications 1 à 35.
